# EUROPÄISCHE PATENTSCHRIFT

(11) **EP 1 388 898 B1**
(45) Veröffentlichungstag und Bekanntmachung des Hinweises auf die Patenterteilung: **11.01.2012**
(21) Anmeldenummer: 02090303.5
(22) Anmeldetag: 27.08.2002
(51) Int. Cl.: H01L 29/82, H01F 10/32

(54) **Halbleiteranordnung zur Injektion eines spinpolarisierten Stroms in einen Halbleiter**
Semiconducting device for injecting a spin polarized current in a semiconductor
Dispositif semiconducteur d'injection d'un courant à spin polarisé dans un semi-conducteur

(30) Priorität: 09.08.2002 EP 02090288
(43) Veröffentlichungstag der Anmeldung: 11.02.2004
(73) Patentinhaber: Freie Universität Berlin, 14195 Berlin (DE)
(72) Erfinder: Fumagalli, Paul, Prof. Dr., 14165 Berlin (DE); Lippitz, Holger, 14055 Berlin (DE); Müller, Christian, 12053 Berlin (DE); Paggel, Jens, Dr., 14129 Berlin (DE)
(74) Vertreter: Baumgärtel, Gunnar

(56) Entgegenhaltungen:
- EP-A- 0 622 791
- US-A1- 2001 031 547
- RUCKER U: "Magnetic coupling phenomena in epitaxial layered systems consisting of iron and the ferromagnetic semiconductor europium sulphide" MAY 1998, GERMANY, XP002223036 JUL-3541
- KAWAGUCHI K ET AL: "(151)Eu and Fe Mossbauer and magnetization study on EuOx/Fe multilayered films" JOURNAL OF MAGNETISM AND MAGNETIC MATERIALS, ELSEVIER SCIENCE PUBLISHERS, AMSTERDAM, NL, Bd. 177-181, Nr. 2002, 1998, Seiten 1186-1188, XP004114252 ISSN: 0304-8853
- KAWAGUCHI K ET AL: "Magnetic properties of Fe/EuO multilayered films" JOURNAL OF MAGNETISM AND MAGNETIC MATERIALS, ELSEVIER SCIENCE PUBLISHERS, AMSTERDAM, NL, Bd. 156, Nr. 1-3, 1. April 1996 (1996-04-01), Seiten 235-236, XP004078671 ISSN: 0304-8853
- DIETL T: "FERROMAGNETIC SEMICONDUCTORS" SEMICONDUCTOR SCIENCE AND TECHNOLOGY, INSTITUTE OF PHYSICS. LONDON, GB, Bd. 17, Nr. 4, April 2002 (2002-04), Seiten 377-392, XP001104640 ISSN: 0268-1242
- WOLF S A ET AL: "Spintronics: a spin-based electronics vision for the future" SCIENCE, 16 NOV. 2001, AMERICAN ASSOC. ADV. SCI, USA, Bd. 294, Nr. 5546, Seiten 1488-1495, XP002223037 ISSN: 0036-8075
- MÜLLER ET AL: "Evidence of exchange-induced", JOURNAL OF APPLIED PHYSICS, vol. 99, no. 7, 1 April 2006 (2006-04-01), - 1 April 2006 (2006-04-01), pages 73904-1-73904-6, DOI: 10.1063/1.2188033
- JOHNSON: "Spin injectzion : a survey and review", J. ORF SUPERCONDCUTIVITY, vol. 14, no. 2, 1 April 2001 (2001-04-01), - 1 April 2001 (2001-04-01), pages 273-281,

## Beschreibung

Die Erfindung betrifft eine Halbleiteranordnung mit einer halbleitenden Schicht und einer hiermit gekoppelten Schicht aus einem ferromagnetischen Material, die in der halbleitenden Schicht einen spinpolarisierten Zustand der halbleitenden Ladungsträger injiziert.

Ziel der Schaffung einer derartigen Anordnung ist es, in einem zur Herstellung von Halbleiterbauelementen verwendbaren halbleitenden Material, wie z.B. GaAs oder Si, einen möglichst hochpolarisierten Spinzustand zu erzeugen, so dass in dem Halbleiterbauelement nicht nur die Ladungsträger als solche sondern zusätzlich auch der Spin der Ladungsträger als Informationsträger dient. Auf diese Weise könnten erheblich kürzere Schaltzeiten erreicht, also schnellere halbleitende Bauelemente (z.B. sogenannte Spin-Transistoren) zu Verfügung gestellt werden.

Ein Problem der vorbeschriebenen Spin-Elektronik (Spintronik) besteht darin, in einem gängigen halbleitenden Material, wie z.B. GaAS oder Si, eine hinreichend große Spinpolarisation zu erreichen.

Hierzu wurde vorgeschlagen, auf eine halbleitende Schicht ein ferromagnetisches Metall aufzubringen. Da in metallischen Ferromagneten der Magnetismus durch die Spinpolarisation der Ladungsträger erzeugt wird, ist ein Strom, der durch einen derartigen Ferromagneten fließt, stets spinpolarisiert. Jedoch ließen sich diese spinpolarisierten Ladungsträger nicht in hinreichendem Umfang in den benachbarten Halbleiter übertragen. Der Grund hierfür liegt darin, dass aufgrund der unterschiedlichen Widerstände von Metall einerseits und Halbleitern andererseits die Injektion der Spinpolarisation von einem Metall in einen Halbleiter sehr ineffizient ist. Dies ist wiederum darauf zurückzuführen, dass der gesamte elektrische Widerstand eines Metall-Halbleiter-Bauelementes durch den Widerstand des Halbleiters bestimmt wird und dieser ist wiederum unabhängig von der Spin-Richtung.

In der US-A-2001/0031547 ist eine Halbleiteranordnung beschrieben, die einen ersten, nicht-magnetischen Halbleiter (INAs) sowie einen aus einem ferromagnetischen Material bestehenden zweiten Halbleiter ((Ga, Mn) Sb) umfasst, die derart miteinander gekoppelt sind, dass im ersten, nicht-magnetischen Halbleiter ein spin-polarisierter Zustand injiziert wird.

Der Erfindung liegt das Problem zugrunde, eine Halbleiteranordnung der eingangs genannten Art zu schaffen, die sich durch eine möglichst große Spinpolarisation der halbleitenden Ladungsträger in der halbleitenden Schicht auszeichnet.

Dieses Problem wird erfindungsgemäß durch die Schaffung einer Halbleiteranordnung mit den Merkmalen des Patentanspruchs 1 gelöst.

Danach ist die (vorzugsweise durch GaAs oder Si gebildete) halbleitende Schicht mit einer zweiten halbleitenden Schicht aus einem ferromagnetischen Material (EuS) gekoppelt, so dass in der ersten halbleitenden Schicht ein spinpolarisierter Zustand der halbleitenden Ladungsträger injiziert wird, wobei die zweite halbleitende Schicht derart mit Ladungsträgern außerhalb der zweiten halbleitenden Schicht, die durch eine zusätzliche Metallschicht zur Verfügung gestellt werden, wechselwirkt, dass die Curie-Temperatur der zweiten halbleitenden Schicht mindestens 250 Kelvin, vorzugsweise mindestens 270 Kelvin und besonders bevorzugt mindestens 300 Kelvin, beträgt.

Die erfindungsgemäße Lösung beruht auf der überraschenden Erkenntnis, dass in einem ferromagnetischen Halbleiter, wie EuS, bei Temperaturen oberhalb der

Zimmertemperatur ein ferromagnetischer Zustand bestehen kann, wenn dieser ferromagnetische Halbleiter mit zusätzlichen (freien) Ladungsträgern wechselwirkt.

Der hierdurch gebildete ferromagnetische Halbleiter, in dem der spinpolarisierte (magnetische) Zustand bei Temperaturen von 250 Kelvin und darüber besteht, eignet sich wiederum zum Injizieren einer Spinpolarisation in der ersten halbleitenden Schicht, die durch einen klassischen (nicht magnetischen) und für schnelle Schaltvorgänge besonders geeigneten Halbleiter, wie z.B. GaAs, Si oder einen anderen Elementhalbleiter bzw. konventionellen III-V oder II-VI Halbleiter gebildet wird. Denn die halbleitenden Eigenschaften der zweiten halbleitenden Schicht gewährleisten, dass der elektrische Widerstand dieser zweiten Schicht vergleichbar mit dem elektrischen Widerstand der ersten halbleitenden Schicht (bestehend aus GaAs bzw. Si) ist, so dass sich die hohe Spinpolarisation der zweiten halbleitenden Schicht durch Kopplung mit der ersten halbleitenden Schicht in diese übertragen lässt.

Der erfindungsgemäßen Lösung stand scheinbar die Tatsache entgegen, dass die bekannten ferromagnetischen Halbleiter Curie-Temperaturen aufweisen, die weit unterhalb 250 Kelvin liegen. So besitzt etwa bei den Eu-Chalkogeniden das Material EuO die höchste Curie-Temperatur von etwa 110 Kelvin. Voraussetzung für die Schaffung der erfindungsgemäßen Lösung war daher die Erkenntnis, dass sich die Curie-Temperaturen in ferromagnetischen Halbleitern bis zu Temperaturen oberhalb 250 Kelvin erhöhen lassen, indem dieses halbleitende, ferromagnetische Material in Wechselwirkung mit weiteren Ladungsträgern gebracht wird.

Die ferromagnetische, zweite halbleitende Schicht kann insbesondere durch eine Verbindung aus einem Element der seltenen Erden und einem zugehörigen Kristallbildner gebildet werden. Die seltenen Erden sind hierfür deshalb besonders gut geeignet, weil es hierunter Elemente mit einer halbgefüllten f-Schale, wie z.B. Eu und Gd gibt, die dementsprechend bei niedrigen Temperaturen einen vollständig spinpolarisierten Grundzustand aufweisen. Als zugeordnete Kristallbildner eignen sich beispielsweise die Chalkogene, wie z.B. O, S oder Se (Elemente der sechsten Gruppe des Periodensystems der Elemente).

Der zugeordnete Kristallbildner sowie ggf. die Stöchiometrie ist jeweils derart zu wählen, dass das für den spinpolarisierten Zustand verantwortliche Element der seltenen Erden gerade diejenige Wertigkeit aufweist, die zu einem magnetischen Grundzustand mit möglichst hoher Spinpolarisation führt. Im Fall von Eu ist dies der zweifach positiv geladene Zustand, so dass sich als Kristallbildner gerade Chalkogene, wie z.B. O oder S, eignen. Bei Gd wird demgegenüber der dreifach positiv geladene Zustand angestrebt, so dass sich als Kristallbildner z.B. N eignet oder bei Verwendung von Chalkogenen eine Stöchiometrie Gd₂X₃ (X=Chalkogen) erforderlich ist.

Als Material für die zweite halbleitende Schicht eignet sich EuS. Diese halbleitende Verbindung zeichnet sich bei niedrigen Temperaturen durch einen spinpolarisierten, ferromagnetischen Zustand aus. Um diesen ferromagnetischen Zustand auch bei höheren Temperaturen, möglichst bis oberhalb 250 Kelvin oder sogar 300 Kelvin, zu erhalten, kann an die zweite halbleitende Schicht angrenzend eine metallische Schicht angeordnet werden, die durch ein ferromagnetisches Übergangsmetall Co, Ni oder eine Legierung solcher Elemente gebildet wird.

Wird die zweite halbleitende Schicht durch einen ferromagnetischen Halbleiter auf der Basis eines Elementes der seltenen Erden, wie EuS, gebildet, so erzeugen die d-Elektronen eines hieran angrenzenden Übergangsmetalles eine Ladungsträgerpopulation in dem an sich leeren d-Band der zweiten halbleitenden Schicht. Hierdurch wird die magnetische Koppelung erhöht und somit auch die Curie-Temperatur des ferromagnetischen Halbleiters.

So ist der Grundzustand der für den Magnetismus verantwortlichen 4f-Elektronen in EuS ein reiner Spinzustand mit einer halbvollen 4f-Schale und das d-artige Leitungsband ist unterhalb der Curie-Temperatur stark spinpolarisiert mit einer Austauschaufspaltung von 0.18 eV. Die Energie dieser Aufspaltung liegt somit weit oberhalb der thermischen Energie von etwa 30 meV bei 300 Kelvin und ist somit auch bei Zimmertemperatur relevant. Dies führt dazu, dass Elektronen im d-artigen Leitungsband vollständig spinpolarisiert sind und ermöglicht die Erhöhung der Curie-Temperatur von EuS durch Wechselwirkung mit den d-Elektronen eines ferromagnetischen Übergangsmetalles.

Im Ergebnis kann also beispielsweise durch die Kombination eines Elementes der seltenen Erden mit einem zugeordneten Kristallbildner ein ferromagnetischer Halbleiter geschaffen werden, der einen ähnlichen Widerstand aufweist wie GaAs oder Si und zudem bei niedrigen Temperaturen einen spinpolarisierten (ferromagnetischen) Zustand aufweist. Die Curie-Temperatur eines solchen ferromagnetischen Halbleiters kann durch Wechselwirkung mit einer Übergangsmetall-Schicht angehoben werden bis auf Zimmertemperatur, d.h. bis auf Temperaturen von 300 Kelvin und darüber, so dass ein derartiger Halbleiter geeignet ist, um beispielsweise in GaAs oder Si einen spinpolarisierten Zustand zu erzeugen. Der GaAs bzw. Si-Halbleiter wird hierzu mit dem vorstehend beschriebenen ferromagnetischen Halbleiter gekoppelt, etwa indem die beiden Halbleiter als aneinander angrenzende Schichten ausgebildet sind.

In einer bevorzugten Weiterbildung der Erfindung und zur Erzielung besonders hoher Curie-Temperaturen in der ferromagnetischen halbleitenden Schicht sind diese halbleitende Schicht sowie die Metallschicht Bestandteile einer Schichtstruktur, bei der Schichten vom Typ der halbleitenden ferromagnetischen Schicht und vom Typ der Übergangsmetallschicht einander abwechselnd übereinander angeordnet sind. Geeignet ist hierbei vor allem eine periodische Schichtstruktur.

Die Dicke der halbleitenden Schichten vom ferromagnetischen Typ ist dabei mindestens so groß, dass sich ein ferromagnetischer Zustand ausbildet, aber nicht größer als die Austauschlänge der spinpolariserten Elektronen mit der angrenzenden Metallschicht.

Die Dicke der (Übergangs-) Metallschichten muss mindestens so groß sein, dass sich im Fall einer ferromagnetischen Schicht die Curie-Temperatur oberhalb 250 K befindet (d.h. für Co mindestens zwei Atomlagen) und im Fall einer unmagnetischen Schicht sich eine geschlossene Lage ausbildet.

Alternativ zur Kopplung der ferromagnetischen halbleitenden Schicht mit einer metallischen Schicht kann die Curie-Temperatur der ferromagnetischen halbleitenden Schicht auch durch geeignete Dotierung der hieran angrenzenden ersten halbleitenden Schicht (GaAs- oder Si-Schicht) erhöht werden.

In einer bevorzugten Ausführungsform der Erfindung grenzt die zweite, ferromagnetische halbleitende Schicht unmittelbar an die (durch GaAs bzw. Si gebildete) erste halbleitende Schicht. Es kann jedoch auch eine zusätzliche Zwischenschicht zwischen den beiden halbleitenden Schichten vorgesehen sein.

Erfindungsgemäß wird die zweite, ferromagnetische halbleitende Schicht durch EuS gebildet und in einer besonders bevorzugten Ausführungsform der Erfindung wird die zur Erhöhung der Curie-Temperatur liegende Metallschicht durch Co gebildet. Diese beiden Schichten sind antiferromagnetisch miteinander gekoppelt, wobei durch diese Koppelung der aneinander grenzenden Schichten die Curie-Temperatur der EuS-Schicht auf Werte oberhalb von 250 Kelvin angehoben werden kann.

Nach einem anderen Aspekt der Erfindung wird eine halbleitende Schicht aus einem ferromagnetischen Material, die derart mit außerhalb der halbleitenden Schicht zur Verfügung gestellten Ladungsträger wechselwirkt, dass die Curie-Temperatur der halbleitenden Schicht oberhalb 250 Kelvin liegt, verwendet als Quelle für spinpolarisierte Elektronen bzw. als Spinfilter zur Elektronendetektion, der z.B. in der Elektronenmikroskopie einsetzbar ist.

Weitere Merkmale und Vorteile der Erfindung werden bei der nachfolgenden Beschreibung eines Ausführungsbeispieles anhand der Figuren deutlich werden.

Es zeigen:
- Fig. 1 -: eine Schichtstruktur zur Erhöhung der Curie-Temperatur in einem ferromagnetischen Halbleiter auf mehr als 300 Kelvin;
- Fig. 2 -: eine magnetooptische Hysteresekurve einer Schichtstruktur gemäß Figur 1 bei 0.85 eV;
- Fig. 3-: eine magnetooptische Hysteresekurve einer Schichtstruktur gemäß Figur 1 bei 3.7 eV;
- Fig. 4a-: eine Anwendung einer Schichtstruktur zur Erhöhung der Curie-Temperatur in einem ferromagnetischen Halbleiter bei einem Spin-Transistor;
- Fig. 4b -: den Spin-Transistor aus Figur 4a bei angelegter Spannung.

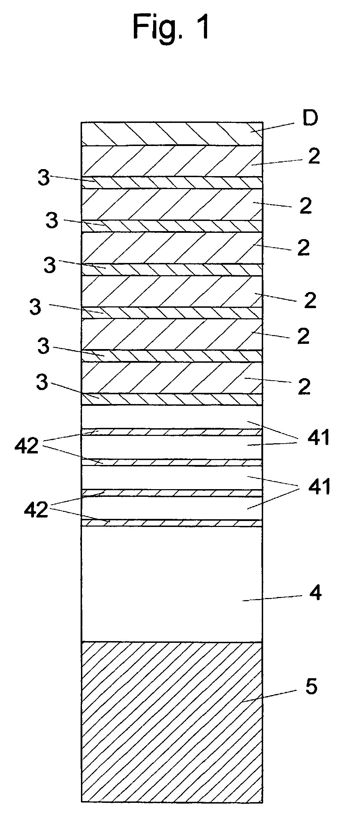

In Figur 1 ist eine Schichtstruktur dargestellt, die sechs Co/EuS-Multilagen umfasst, also sechs halbleitende EuS-Schichten 2, die jeweils auf einer Co-Schicht 3 angeordnet sind, wobei sechs derartige Co/EuS-Lagen 2, 3 übereinander angeordnet sind. Als Substrat für die Co/EuS-Multilagen dienen Co/Pt-Vieifachschichten 41, 42, mit jeweils einer Pt-Schicht 41 auf einer Co-Schicht 42. Diese werden nach unten abgeschlossen durch eine dickere Pt-Schicht 4, die auf einem nasschemisch gereinigten Si(111)-Wafer 5 angeordnet ist. Nach oben abgeschlossen wird die in Figur 1 dargestellte Schichtstruktur durch eine Co-Deckschicht D.

Bei den EuS-Schichten 2 handelt es sich um Schichten aus einem halbleitenden, bei tiefen Temperaturen ferromagnetischen Material, das zur Erzeugung eines spinpolarisierten Zustandes in einem für Halbleiterbauelemente zu verwendenden Halbleiter, wie. z.B. GaAs bzw. Si, dienen soll, der anstelle der Deckschicht D auf der obersten EuS-Schicht 2 der Schichtstruktur aufgebracht wird. Die Co-Schichten 3 der Co/EuS-Multilagen dienen zur Erhöhung der Curie-Temperatur in den EuS-Schichten 2, so dass die ferromagnetische Ordnung in diesen Schichten auch bei Temperaturen von 300 Kelvin und mehr besteht. (Die minimale Anzahl der Co/EuS-Doppellagen beträgt eins.) Bei einer derart hohen Curie-Temperatur können die EuS-Schichten 2 verwendet werden, um bei Zimmertemperatur einen spinpolarisierten Zustand in GaAs oder Si zu erzeugen, ohne dass hierfür eine Kühlung erforderlich wäre.

Der Zweck der Co/Pt-Vielfachschichten 41, 42 liegt lediglich in der Induzierung einer senkrechten magnetischen Anisotropie (d.h. senkrecht zur Oberfläche der Schichtanordnung) in den darüberliegenden Co- und EuS-Schichten 2, 3, um den Nachweis der ferromagnetischen Ordnung in den EuS-Schichten mittels des polaren Kerr-Effektes zu erleichtern. Bei einem Einsatz der Co/EuS-Multilagen 2, 3 zur Erzeugung eines spinpolarisierten Zustandes in GaAs oder Si sind diese Co/Pt-Mehrfachlagen 41, 42 nicht erforderlich.

Für die auf einer dickeren Pt-Schicht 4 angeordneten Co/Pt-Mehrfachlagen dient der nasschemisch gereinigte und auf Temperaturen oberhalb 1000°C erhitzte ("geflashte") Si(111)-Wafer als Substrat, der durch den Reinigungsprozess weitgehend von metallischen und organischen Verunreinigungen befreit ist.

Nachfolgend einige Einzelheiten zur Herstellung einer Anordnung gemäß Figur 1.

Die Substrat-Grundfläche beträgt ca. 12x12 mm². Das Substrat wird in eine UHV-Elektronenstrahl-Verdampfungsanlage (ESV) eingeschleust, wo es bei einem Basisdruck von ca. 1· 10⁻⁹ mbar kurzzeitig auf minimal 1000°C erhitzt (geflasht) wird. (Eine genaue Temperaturbestimmung ist an der Position der Probe nicht möglich) Durch den Erhitzungsprozess stellt sich auf der Silizium-Oberfläche eine 7x7-Oberflächen-Rekonstruktion ein, die mit der Reflection-High-Energy-Electron-Diffraction-Methode (RHEED) nachgewiesen wird (1 mbar entspricht 100 Pa).

Nach Abkühlung der Probe unterhalb 50°C wird bei einem Ausgangsdruck von weniger als 3· 10⁻⁹ mbar und einer Elektronen-Beschleunigungsspannung von 10kV eine 50Å-dicke Pt-Pufferschicht aufgedampft. Die Wachstumsrate beträgt hierbei ca. 0.3 Ås⁻¹; direkt nach dem Wachstumsprozess ist der Druck kleiner als 9· 10⁻⁸ mbar (1Å entspricht 0,1 nm).

Der Ausgangsdruck vor dem Aufdampfen aller weiteren Schichten ist immer kleiner als 3· 10⁻⁹ mbar; die Temperatur liegt unterhalb von 40°C; die Elektronen-Beschleunigungsspannung beträgt für das Aufdampfen von Platin und Kobalt 10 kV und für EuS 7 kV. Zur Herstellung eines magnetischen Substrats für die EuS/Co-Schichtsysteme werden vier Doppellagen Co/Pt aufgebracht. Die Wachstumsrate der 3Å-dicken Co-Schichten beträgt ca. 0,07 Ås⁻¹, diejenige der 11 Å-dicken Pt-Schichten beträgt ca. 0,3 Ås⁻¹. Der Druck jeweils kurz nach dem Aufdampfen der Lagen ist immer niedriger als 2· 10⁻⁸ mbar

Um die magnetooptischen Eigenschaften der Co/Pt-Mehrfachlagen untersuchen zu können, werden die Proben nun aus der ESV-Kammer ausgeschleust und an Atmosphäre zur Hälfte mit einem Tantal-Blech abgedeckt. Danach werden die Proben zum Aufdampfen der EuS/Co-Schichten wieder in die Kammer gebracht, wobei eine erste Probe A mit 5 Å-dicken Co-Lagen und 27,7 Å-dicken EuS-Lagen sowie eine zweite Probe B mit 5 Å-dicken Co-Lagen und 13,8 Å-dicken EuS-Lagen hergestellt wird. Die Wachstumsraten der 5 Å-dicken Co-Lagen beträgt ca. 0,1 Ås⁻¹, diejenige der 27,7 Å-dicken EuS-Lagen beträgt ca. 0,3 Ås⁻¹ (Probe A), diejenige der 13,8 Å-dicken EuS-Lagen beträgt ca. 0,25 Ås⁻¹ (Probe B). Als Deckschicht wird schließlich auf beide Proben eine 10 Å-dicke Co-Lage, mit einer Wachstumsrate von ca. 0,14 Ås⁻¹ (Probe A) bzw. 0,2 Ås⁻¹ (Probe B) aufgebracht.

Der genaue Aufbau der Schichten mit Abmessungen gemäß Probe B ist in Figur 1 gezeigt und weiter oben bereits beschrieben worden.

In derartigen Schichtstrukturen ließ sich ferromagnetische Ordnung in den EuS-Schichten bei 300 Kelvin nachweisen, und zwar auf der Grundlage des magnetooptischen polaren Kerr-Effektes. Der magnetooptische polare Kerr-Effekt misst ein Signal, welches proportional zur Komponente der Magnetisierung senkrecht zur Schichtebene ist. Der Nachweis der ferromagnetischen Ordnung mithilfe des polaren Kerr-Effekts beruht dabei auf folgenden zwei Annahmen:
1. Das magnetische Verhalten von EuS und Co lässt sich durch geeignete Wahl der Lichtenergie unterscheiden. Dies liegt an der unterschiedlichen spektralen Abhängigkeit des Co- und des EuS-Kerr-Spektrums. EuS mit seinen lokalisierten 4f-Elektronen zeigt eine charakteristische Linienform, die einem liegenden "S" gleicht, wohingegen Co sich durch eine nur schwache spektrale Abhängigkeit des Kerr-Spektrums auszeichnet. Insbesondere zeigt Co Beiträge zum Kerr-Effekt im nahen Infrarotbereich (d.h. unterhalb von 1 eV), wo EuS keine magnetooptische Aktivität zeigt, da diese Energie geringer als die Bandlücke des Halbleiters ist. Somit können unterhalb von 1 eV im Wesentlichen die magnetischen Eigenschaften der Co-Schichten gemessen werden. Dort, wo die lokalen 4f-Elektronen von EuS ihren Beitrag zum magnetooptischen Signal machen (bei ca. 2eV und - wegen der Kristallfeldaufspaltung des d-Leitungsbandes - auch bei ca. 4eV) werden hingegen hauptsächlich die magnetischen Eigenschaften der EuS-Schichten gemessen.
2. Wenn zwei magnetische Untersysteme antiferromagnetisch gekoppelt sind, dann müssen die beiden Untersysteme jedes für sich ferromagnetisch geordnet sein. Ohne äußeres Magnetfeld sind die beiden magnetischen Untersysteme Co und EuS antiferromagnetisch gekoppelt. Wird nun ein starkes Magnetfeld angelegt, so kann die antiferromagnetische Kopplung aufgehoben werden. Als Folge davon richtet sich das ursprünglich antiparallel ausgerichtete Subsystem nun zunehmend parallel zum (magnetisch) dominanten Subsystem aus.

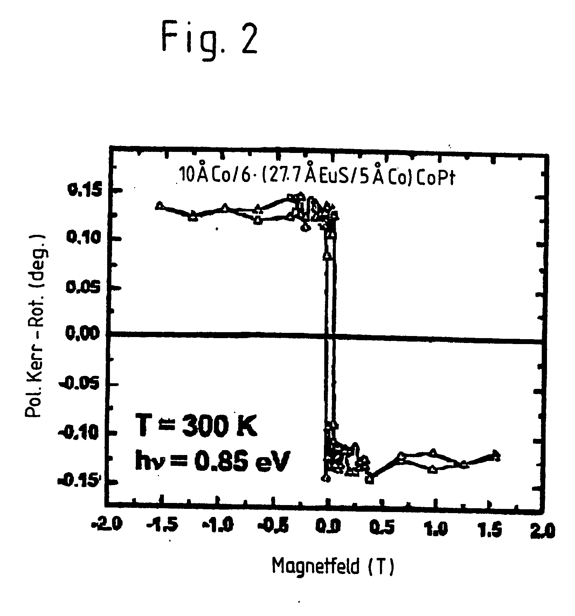

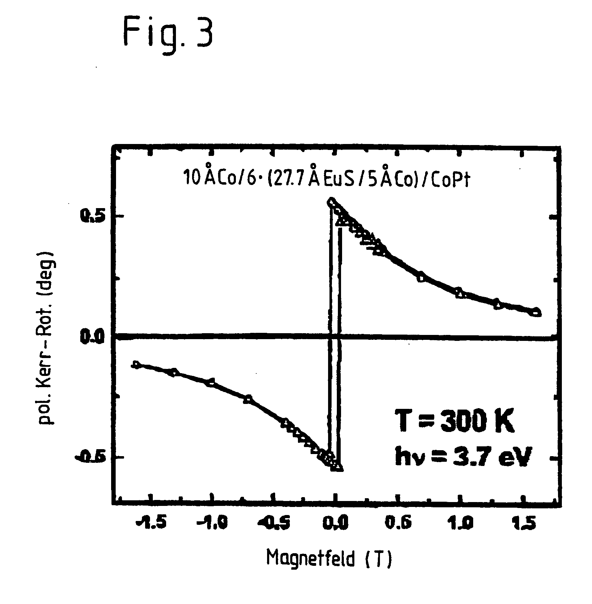

Durch Messung der Kerr-Rotation in Abhängigkeit vom angelegten Magnetfeld bei zwei Lichtenergien, bei denen einmal das Co- und dann das EuS-Subsystem magnetooptisch vorherrschend ist, sollten sich charakteristische Unterschiede in den Kurven zeigen. Analysiert wurden die entsprechenden, in den Figuren 2 und 3 für die Probe A dargestellten magnetooptischen Kurven als Funktion des äußeren Magnetfelds bei 0.85 eV (Co-Anteil des magnetooptischen Signals, Fig. 2) und bei 3.7 eV (EuS-Anteil des magnetooptischen Signals, Fig. 3). Man erkennt hierbei deutlich die ferromagnetische Ordnung in den Co-Schichten. Bei den EuS-Schichten. wird deutlich der nichtlineare Verlauf der Hysteresekurve sichtbar. Bei hohen Magnetfeldern bricht die antiferromagnetische Kopplung zu den Co-Schichten auf und die magnetischen Momente von EuS richten sich nun parallel zu denjenigen von Co aus. Daraus folgt aber, dass die EuS-Schichten für sich auch ferromagnetisch geordnet sein müssen bei 300 K.

Durch die in der vorstehend beschriebenen Weise an Co-Schichten 3 gekoppelten EuS-Schichten 2 wird ein ferromagnetisches, halbleitendes Material mit einem vollständig spinpolarisierten Grundzustand zur Verfügung gestellt, welches für Anwendungen in der Spin-Elektronik (Spintronik) drei wichtige Vorteile aufweist:
- Das Material ist halbleitend und damit hinsichtlich des elektrischen Widerstandes angepasst an die in der Halbleiterindustrie üblichen GaAs- bzw. Si-Halbleiter.
- Das Material ist selbst bei Zimmertemperatur ferromagnetisch und ermöglicht somit die Erzeugung einer hohen Spinpolarisation in GaAs bzw. Si, ohne dass Kühlung erforderlich wäre.
- Der Grundzustand des Materials ist vollständig spinpolarisiert. Dies garantiert einen optimalen Spinfilter-Effekt, d.h. eine optimale Spin-Injektion in einen angrenzenden GaAs- bzw. Si-Halbleiter.

Die EuS-Schicht bildet also eine optimale Spin-Injektionsschicht für die Spin-Elektronik.

Entscheidend hierbei ist, dass durch Stapeln von EuS- und Co-Schichten die Curie-Temperatur von EuS auf einen Wert oberhalb der Zimmertemperatur angehoben werden konnte. Der Nachweis dieser Eigenschaft wurde mittels der oben beschriebenen magnetooptischen Messungen auf der Grundlage des polaren Kerr-Effektes geführt.

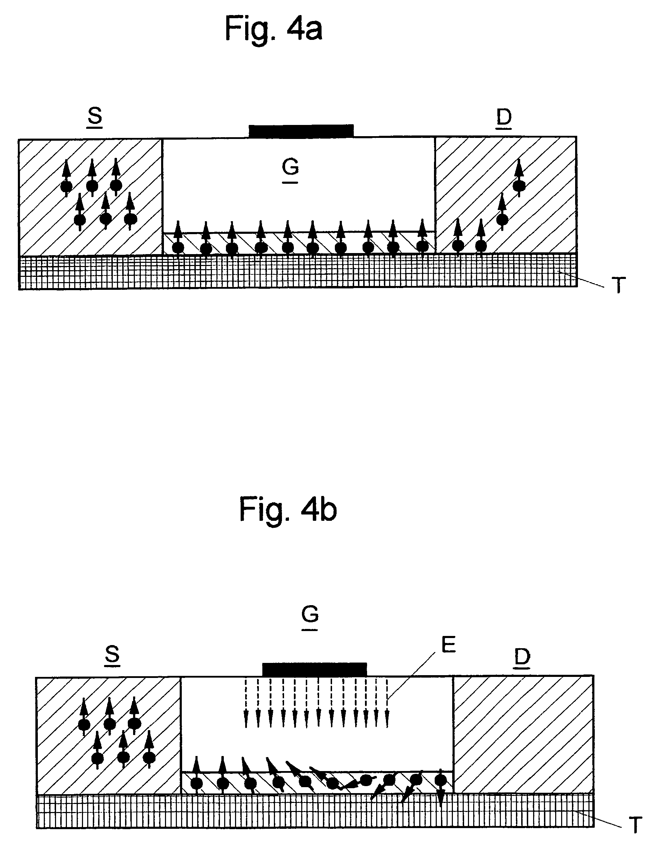

Figur 4a zeigt eine Anwendung einer Co/EuS-Schichtstruktur zur Spin-Injektion in einem GaAs-Halbleiter bei einem Spin-Transistor in Form eines Feldeffekt-Transistors. Der in Figur 4a dargestellte Feldeffekt-Transistor ist angeordnet auf einem halbleitenden Substrat T und umfasst einen Sourcebereich S, einen Gatebereich G sowie einen Drainbereich D.

Der Gatebereich G wird in bekannter Weise gebildet durch eine halbleitende Heterostruktur, insbesondere unter Verwendung eines II-VI- oder III-V-Halbleiters, wie z.B. GaAs. Der Sourcebereich S und der Drainbereich D werden jeweils gebildet durch eine Schichtstruktur, die mindestens eine Schicht aus einem ferromagnetischen Halbleiter, EuS, und eine hieran angrenzende metallische Schicht aus einem Übergangsmetall, z.B. Co, aufweist. Die Kopplung der Schicht aus einem ferromagnetischen, halbleitenden Material an eine metallische Schicht dient dabei der Erhöhung der Curie-Temperatur in dem ferromagnetischen halbleitenden Material wie zuvor anhand Figur 1 beschrieben. Die den Source- bzw. Drainbereich bildende Schichtstruktur weist dabei jeweils mindestens eine metallische Schicht und mindestens eine Schicht aus einem ferromagnetischen, halbleitenden Material auf. Es können jedoch auch mehrere derartiger Schichten vorgesehen sein.

Wegen der Verwendung eines ferromagnetischen, halbleitenden Materials zur Bildung des Sourcebereichs S des in Figur 4a dargestellten Spin-Transistors wird in dem aus GaAs oder einem anderen konventionellen Halbleiter bestehenden Gatebereich G ein spinpolarisierter (2D-) Elektronenstrom injiziert, wobei die Elektronen mit unverändertem Spin vom Sourcebereich S zum Drainbereich D gelangen. Der Spin einzelner Elektronen ist dabei in Figur 4a schematisch durch Pfeile angedeutet, die jeweils die Orientierung des Spins andeuten.

Figur 4b zeigt den Spin-Transistor aus Figur 4a nach Anlegen einer elektrischen Spannung, so dass am Gatebereich G ein elektrisches Feld E wirkt, wodurch der Spin der im Gatebereich G befindlichen Elektronen gedreht wird. Aufgrund dieser Polarisationsänderung werden die Elektronen an der Grenzschicht zwischen Gatebereich G und Drainbereich D zurückgewiesen.

## Patentansprüche

1. Halbleiteranordnung mit
- einer ersten halbleitenden Schicht (G) und
- einer zweiten halbleitenden Schicht (2) aus einem ferromagnetischen Material, die derart mit der ersten halbleitenden Schicht (G) gekoppelt ist, dass in der ersten halbleitenden Schicht (G) ein spinpolarisierter Zustand der halbleitenden Ladungsträger injiziert wird,
wobei die zweite halbleitende Schicht (2) durch EuS gebildet wird und mit außerhalb der zweiten halbleitenden Schicht (2) durch eine an die zweite halbleitende Schicht (2) angrenzende metallische Schicht (3) zur Verfügung gestellten Ladungsträgern wechselwirkt und wobei ferner
a) die metallische Schicht (3) durch Co, Ni oder eine Legierung unter Verwendung solcher Elemente gebildet wird,
b) die zweite halbleitende Schicht (2) und die metallische Schicht (3) Bestandteile einer Schichtstruktur sind, bei der die Schichten vom Typ der zweiten halbleitenden Schicht (2) und vom Typ der Metallschicht (3) einander abwechselnd übereinander angeordnet sind, und
c) die Curie-Temperatur der zweiten halbleitenden Schicht (2) durch die Wechselwirkung mit den in der metallischen Schicht (3) zur Verfügung gestellten Ladungsträgern bei mindestens 250 Kelvin liegt.

2. Halbleiteranordnung nach Anspruch 1, **dadurch gekennzeichnet, dass** die erste halbleitende Schicht (1) durch ein im Grundzustand nicht spinpolarisiertes Material gebildet wird.

3. Halbleiteranordnung nach Anspruch 1 oder 2, **dadurch gekennzeichnet, dass** die erste halbleitende Schicht (1) durch ein halbleitendes Material auf GaAs- oder Si-Basis gebildet wird.

4. Halbleiteranordnung nach einem der vorhergehenden Ansprüche, **dadurch gekennzeichnet, dass** die zweite halbleitende Schicht (2) durch eine Verbindung aus einem Element mit einem vollständig spinpolarisierten Grundzustand und einem zugehörigen Kristallbildner gebildet wird.

5. Halbleiteranordnung nach einem der vorhergehenden Ansprüche, **dadurch gekennzeichnet, dass** der Kristallbildner ein Element der fünften oder sechsten Hauptgruppe des Periodensystems der Elemente ist.

6. Halbleiteranordnung nach einem der vorhergehenden Ansprüche, **dadurch gekennzeichnet, dass** die Schichtstruktur als periodische Schichtstruktur ausgebildet ist.

7. Halbleiteranordnung nach einem der vorhergehenden Ansprüche, **dadurch gekennzeichnet, dass** die Dicke der zweiten halbleitenden Schicht (2) zwischen 2Å und 1000Å (0.2 und 100nm) vorzugsweise zwischen 5Å und 200Å (0,5 und 20nm), liegt.

8. Halbleiteranordnung nach einem der vorhergehenden Ansprüche, **dadurch gekennzeichnet, dass** die Dicke der Metallschicht mindestens zwei Atomlagen beträgt, insbesondere zwischen 2Å und 1000Å (0,2 und 100nm), liegt.

9. Halbleiteranordnung nach einem der vorhergehenden Ansprüche, **dadurch gekennzeichnet, dass** die mit der zweiten halbleitenden Schicht (2) wechselwirkenden Ladungsträger durch Dotierung der ersten halbleitenden Schicht (1) zur Verfügung gestellt werden.

10. Halbleiteranordnung nach einem der vorhergehenden Ansprüche, **dadurch gekennzeichnet, dass** die zweite halbleitende Schicht (2) unmittelbar an die erste halbleitende Schicht (1) grenzt oder dass die zweite halbleitende Schicht (2) über eine Zwischenschicht an die erste halbleitende Schicht (1) grenzt.

11. Halbleiteranordnung nach einem der vorhergehenden Ansprüche, **dadurch gekennzeichnet, dass** die zweite halbleitende Schicht (2) durch EuS und die Metallschicht (3) durch Co gebildet wird.

12. Verwendung einer Halbleiteranordnung nach einem der Ansprüche 1 bis 8 als Quelle für spinpolarisierte Elektronen und/oder zur Elektronendetektion.

## Claims

1. Semiconductor device with
a first semiconducting layer (G) and
a second semiconducting layer (2) of a ferromagnetic material, which is linked to the first semiconducting layer (G) such that within the first semiconducting layer (G) a spin polarized status of the semiconducting charge carrier is injected,
wherein the second semiconducting layer (2) is formed by EuS and interacts with charge carriers being provided outside of the second semiconducting layer (2) by a metallic layer (3) being adjacent to the second semiconducting layer (2) and wherein furthermore
a) the metallic layer (3) is formed by Co, Ni or an alloy using such elements,
b) the second semiconducting layer (2) and the metallic layer (3) are constituents of a layer structure, in which the layers of the type of the second semiconducting layer (2) and the type of the metallic layer (3) are arranged alternating above each other, and
c) the Curie-temperature of the second semiconducting layer (2) is at least 250 K due to the interaction with the charge carriers provided in the metallic layer (3).

2. Semiconductor device according to claim 1, **characterized in that** the first semiconducting layer (1) is formed by a material being not spin polarized in the basic state.

3. Semiconductor device according to claim 1 or 2, **characterized in that** the first semiconducting layer (1) is formed by a semiconducting material on the basis of GaAs or Si.

4. Semiconductor device according to one of the preceding claims, **characterized in that** the second semiconducting layer (2) is formed by a combination of an element with a completely spin polarized basic state and an assigned crystal former.

5. Semiconductor device according to one of the preceding claims, **characterized in that** the crystal former is an element of the 5^{th} or 6^{th} main group of the Periodic System of the Elements.

6. Semiconductor device according to one of the preceding claims, **characterized in that** the layer structure is formed as a periodic layer structure.

7. Semiconductor device according to one of the preceding claims, **characterized in that** the thickness of the second semiconducting layer (2) is between 2 Å and 1000 Å (0.2 and 100 nm), preferably between 5 Å and 200 Å (0.5 and 20 nm).

8. Semiconductor device according to one of the preceding claims, **characterized in that** the thickness of the metal layer is at least two atomic layers, in particular between 2 A and 1000 Å (0.2 and 100 nm).

9. Semiconductor device according to one of the preceding claims, **characterized in that** the charge carriers interacting with the second semiconducting layer (2) are provided by doping the first semiconducting layer (1).

10. Semiconductor device according to one of the preceding claims, **characterized in that** the second semiconducting layer (2) is directly adjacent to the first semiconducting layer (1) or that the second semiconducting layer (2) is adjacent to the first semiconducting layer (1) via an in-between layer.

11. Semiconducting device according to one of the preceding claims, **characterized in that** the second semiconducting layer (2) is formed by EuS and the metal layer (3) is formed by Co.

12. Use of a semiconductor device according to one of the claims 1 to 8 as source for spin polarized electrons and/or for detecting electrons.

## Revendications

1. Dispositif semi-conducteur, comprenant :
- une première couche semi-conductrice (G), et
- une deuxième couche semi-conductrice (2) en matériau ferromagnétique, qui est couplée à la première couche semi-conductrice (G) de telle sorte qu'un état polarisé en spin des porteurs de charge semi-conducteurs soit injecté dans la première couche semi-conductrice (G),
dans lequel la deuxième couche semi-conductrice (2) est formée en EuS et interagit avec des porteurs de charge fournis en dehors de la deuxième couche semi-conductrice (2) par une couche métallique (3) adjacente à la deuxième couche semi-conductrice (2), et dans lequel en outre :
a) la couche métallique (3) est formée par Co, Ni ou un alliage utilisant ces éléments,
b) la deuxième couche semi-conductrice (2) et la couche métallique (3) sont des composants d'une structure de couches dans le cadre de laquelle les couches du type de la deuxième couche semi-conductrice (2) et du type de la couche métallique (3) sont disposées les unes au-dessus des autres en alternance, et
c) la température de Curie de la deuxième couche semi-conductrice (2) est d'au moins 250 Kelvin dû à l'interaction avec les porteurs de charge fournis dans la couche métallique (3).

2. Dispositif semi-conducteur selon la revendication 1, **caractérisé en ce que** la première couche semi-conductrice (1) est formée par un matériau non polarisé en spin à l'état fondamental.

3. Dispositif semi-conducteur selon la revendication 1 ou 2, **caractérisé en ce que** la première couche semi-conductrice (1) est formée par un matériau semi-conducteur à base de GaAs ou Si.

4. Dispositif semi-conducteur selon l'une quelconque des revendications précédentes, **caractérisé en ce que** la deuxième couche semi-conductrice (2) est formée par une combinaison d'un élément ayant un état fondamental entièrement polarisé en spin et d'un élément de cristallisation associé.

5. Dispositif semi-conducteur selon l'une quelconque des revendications précédentes, **caractérisé en ce que** l'élément de cristallisation est un élément du cinquième ou sixième groupe principal de la classification périodique des éléments.

6. Dispositif semi-conducteur selon l'une quelconque des revendications précédentes, **caractérisé en ce que** la structure de couche est réalisée comme une structure de couche périodique.

7. Dispositif semi-conducteur selon l'une quelconque des revendications précédentes, **caractérisé en ce que** l'épaisseur de la deuxième couche semi-conductrice (2) se situe entre 2 Å et 1000 Å (0,2 et 100 nm), de préférence entre 5 Å et 200 Å (0,5 et 20 nm).

8. Dispositif semi-conducteur selon l'une quelconque des revendications précédentes, **caractérisé en ce que** l'épaisseur de la couche métallique correspond à au moins deux couches atomiques, se situant en particulier entre 2 Å et 1000 Å (0,2 et 100 nm).

9. Dispositif semi-conducteur selon l'une quelconque des revendications précédentes, **caractérisé en ce que** les porteurs de charge interagissant avec la deuxième couche semi-conductrice (2) sont fournis par un dopage de la première couche semi-conductrice (1).

10. Dispositif semi-conducteur selon l'une quelconque des revendications précédentes, **caractérisé en ce que** la deuxième couche semi-conductrice (2) est directement adjacente à la première couche semi-conductrice (1) ou **en ce que** la deuxième couche semi-conductrice (2) aboutit à la première couche semi-conductrice (1) en passant par une couche intermédiaire.

11. Dispositif semi-conducteur selon l'une quelconque des revendications précédentes, **caractérisé en ce que** la deuxième couche semi-conductrice (2) est réalisée en EuS et la couche métallique (3) est réalisée en Co.

12. Utilisation d'un dispositif semi-conducteur selon l'une quelconque des revendications 1 à 8 comme une source d'électrons polarisés en spin et/ou pour la détection d'électrons.
